(19) **Europäisches Patentamt**
**European Patent Office**
**Office européen des brevets**

(11) **EP 4 692 742 A1**

(12) **EUROPEAN PATENT APPLICATION**
published in accordance with Art. 153(4) EPC

(43) Date of publication:
**11.02.2026 Bulletin 2026/07**

(51) International Patent Classification (IPC):
**G01J 5/70** (2022.01)     **G01J 5/00** (2022.01)
**G01J 5/60** (2006.01)     **H01L 21/66** (2006.01)

(21) Application number: **24810682.5**

(52) Cooperative Patent Classification (CPC):
**G01J 5/00; G01J 5/60; G01J 5/70; H01L 22/00**

(22) Date of filing: **15.03.2024**

(86) International application number:
**PCT/JP2024/010200**

(87) International publication number:
**WO 2024/241674 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.05.2023 JP 2023085975**
**14.09.2023 JP 2023149273**

(71) Applicant: **HORIBA, Ltd.**
**Kyoto-shi Kyoto 601-8510 (JP)**

(72) Inventors:
• **FUJINO, Sho**
**Kyoto-shi, Kyoto 601-8510 (JP)**
• **TOMINAGA, Koji**
**Kyoto-shi, Kyoto 601-8510 (JP)**

(74) Representative: **Isarpatent**
**Patent- und Rechtsanwälte Partg mbB**
**Friedrichstraße 31**
**80801 München (DE)**

(54) **RADIATION TEMPERATURE MEASUREMENT DEVICE, RADIATION TEMPERATURE MEASUREMENT METHOD, AND PROGRAM FOR RADIATION TEMPERATURE MEASUREMENT DEVICE**

(57) There is provided a radiation temperature measurement device that measures a temperature of a measurement target having a substrate and a thin film which is formed on a surface of that substrate. This radiation temperature measurement device includes an infrared detection unit that detects an amount of infrared radiation emitted from the measurement target, a substrate spectral characteristics data storage unit in which substrate spectral characteristics data showing a temperature dependence of the spectral characteristics of the substrate is stored, an individual spectral characteristics data receiving unit that receives inputs of individual spectral characteristics data showing information relating to a reflectivity and transmissivity at a predetermined temperature of the measurement target, a spectral characteristics calculation unit that calculates the temperature dependence of the spectral characteristics of the measurement target based on the substrate spectral characteristics data and the individual spectral characteristics data, and a temperature calculation unit that calculates the temperature of the measurement target based on the amount of infrared radiation detected by the infrared detection unit and on the temperature dependence of the spectral characteristics of the measurement target calculated by the spectral characteristics calculation unit.

FIG.3

EP 4 692 742 A1

**Description**

[Technical Field]

The present invention relates to a non-contact type of radiation temperature measurement device that receives infrared radiation emitted from a measurement target area using an infrared sensor (for example, a thermopile), and then measures a temperature of the measurement target area from the received amount of infrared radiation, and to a radiation temperature measurement method, and a program for a radiation temperature measurement device.

[Technical Background]

Conventionally, a non-contact type of radiation temperature measurement device that detects infrared radiation emitted from a measurement target area using an infrared sensor (for example, a thermopile), and then measures a temperature of the measurement target area from the detected amount of infrared radiation is widely known.

In this radiation temperature measurement device, it is sometimes difficult to accurately measure the temperature of a measurement target area due to the fact that not only is the infrared radiation emitted from the measurement target area detected, but so is infrared radiation that is transmitted from the background thereof.

In order to solve problems such as this, a radiation temperature measurement device has been disclosed in Patent Document 1 that is equipped with two infrared detection units that detect mutually different infrared wavelength ranges, and that, based on the infrared radiation amounts detected by these two infrared detection units, calculates the temperature of the measurement target area.

More specifically, a temperature of a measurement target area is calculated in the following manner.

A total amount of infrared radiation in a predetermined wavelength range that enters the infrared detection units from a measurement target area is a sum of infrared radiation A1 from the measurement target area, infrared radiation A2 from a background thereof, and infrared radiation A3 reflected by the measurement target area. In a case in which the infrared ray detection units and the measurement target area are directly facing each other, the infrared radiation A3 is known as this is infrared radiation from the infrared detection units. Accordingly, a ratio R between A1 and A2 is determined as A1/A2, in other words, as the emissivity/transmissivity of the measurement target area.

Because the infrared wavelength ranges detected by the two infrared detection units are mutually different, the ratio R between A1 and A2 becomes R1 and R2 in the respective infrared detectors. Accordingly, by using simultaneous equations or a bisection method, it is possible to calculate the temperature of the measurement target area from an amount of infrared radiation detected by one of the infrared detection units and an amount of infrared radiation detected by the other of the infrared detection units, and from the known ratios R1 and R2 in the respective wavelength ranges.

[Documents of the Prior Art]

[Patent Documents]

[Patent Document 1] International Patent Publication No. 2021/080002

[Disclosure of the Invention]

[Problems to be Solved by the Invention]

However, in the above-described radiation temperature measurement device, it is necessary that the ratios R1 and R2 in the respective wavelength ranges of the measurement target be determined in advance prior to starting the temperature measurement. In a case in which the measurement target is an object in which a thin film is formed on a surface of a substrate such as a silicon wafer used in semiconductor manufacturing, the temperature dependence of the spectral characteristics thereof changes depending on the material used to form the thin film and on the thickness thereof. Because of this, in order to actually obtain the temperature dependence of the spectral characteristics, it is necessary to measure the spectral characteristics at a plurality of temperatures for each of the samples formed from different materials and having different film thicknesses. As a consequence, an enormous period of time is taken up by the preliminary preparations that are needed in order to measure the temperature of the measurement target.

The present invention was therefore conceived in order to solve the above-described problems, and it is a principal initial object thereof to shorten the length of time that is required, prior to performing a temperature measurement, in order to acquire a temperature dependence of the spectral characteristics of the measurement target in a radiation temperature measurement device that measures a temperature of a measurement target in which a thin film is formed on a surface of a substrate.

[Means for Solving the Problem]

After performing intensive investigations in order to solve the above-described problems, the inventors of the present application discovered that, in a semiconductor wafer or the like in which, for example, a thin film is formed on a surface of a silicon substrate, although the spectral characteristics of the substrate itself are temperature-dependent, the temperature dependence of the spectral characteristics of the actual thin film that is formed on the surface of the substrate are small enough so as to be considered constant irrespective of the temperature. After subsequently performing further intensive investigations, the inventors of the present application discovered that, if the temperature dependence of the spectral characteristics of the substrate itself was prepared in advance, then simply by measuring the spectral characteristics of the measurement target at a single arbitrary temperature, it was possible to estimate the spectral characteristics of the thin film itself. As a consequence, they discovered that the spectral characteristics at each temperature of the measurement target could be estimated and, as a result, were able to develop the present invention.

In other words, a radiation temperature measurement device according to the present invention measures a temperature of a measurement target having a substrate and a thin film which is formed on a surface of that substrate, and is characterized in being provided with an infrared detection unit that detects an amount of infrared radiation emitted from the measurement target, a substrate spectral characteristics data storage unit in which substrate spectral characteristics data showing a temperature dependence of the spectral characteristics of the substrate is stored, an individual spectral characteristics data receiving unit that receives inputs of individual spectral characteristics data showing information relating to a reflectivity and transmissivity at a predetermined temperature of the measurement target, a spectral characteristics calculation unit that calculates the temperature dependence of the spectral characteristics of the measurement target based on the substrate spectral characteristics data and the individual spectral characteristics data, and a temperature calculation unit that calculates the temperature of the measurement target based on the amount of infrared radiation detected by the infrared detection unit and on the temperature dependence of the spectral characteristics of the measurement target calculated by the spectral characteristics calculation unit.

If this type of structure is employed, then if a user simply measures the reflectivity and transmissivity of the measurement target at a predetermined temperature and then inputs the measurement results, the temperature dependence of the spectral characteristics of the measurement target are calculated based on the reflectivity and transmissivity of the measurement target at the predetermined temperature, and on the temperature dependence of the spectral characteristics of the actual substrate itself. As a result, it is not necessary to measure the spectral characteristics at a plurality of temperatures of each sample that is made from a different material and has a different film thickness, as is the case conventionally, so that the time required to perform the preliminary preparations necessary when measuring the temperature of a measurement target can be considerably shortened.

As a specific aspect of the above-described radiation temperature measurement device, it is desirable that the spectral characteristics calculation unit calculate the reflectivity and transmissivity at a predetermined temperature of the thin film based on the temperature dependence of the spectral characteristics shown by the substrate spectral characteristics data and on the reflectivity and transmissivity of the measurement target at the predetermined temperature shown by the individual spectral characteristics data, and also calculate the temperature dependence of the spectral characteristics of the measurement target using the calculated reflectivity and transmissivity at a predetermined temperature of the thin film, and the temperature dependence of the spectral characteristics of the substrate shown by the substrate spectral characteristics data.

Moreover, after performing further intensive investigations, the inventors of the present application discovered that the temperature dependence of the spectral characteristics of the substrate itself can be easily calculated from empirical laws by utilizing information relating to the physical properties of the substrate (for example, the electrical resistivity thereof). In particular, the inventors of the present application discovered that a strong correlation exists between the electrical resistivity of a substrate (or the impurity concentration thereof), and the refractive index and extinction coefficient thereof, and that by using this correlation it is possible to calculate the temperature dependence of the spectral characteristics of the substrate itself based on the electrical resistivity of the substrate.

Therefore, as a specific aspect of the above-described radiation temperature measurement device that is used to calculate the temperature dependence of the spectral characteristics of the measurement target, it is desirable that the radiation temperature measurement device be further provided with a substrate physical property data storage unit that stores substrate physical property data showing information relating to physical properties of the substrate, a correlation data storage unit that stores first correlation data showing a correlation between an electrical resistivity, a temperature, and a refractive index of the substrate, and second correlation data showing a correlation between an electrical resistivity, a temperature, and an extinction coefficient of the substrate, and a substrate spectral characteristics calculation unit that calculates the temperature dependence of the spectral characteristics of the substrate based on the electrical resistivity of the substrate shown by the substrate physical properties data, a correlation shown by the first correlation data, and a correlation shown by the second correlation data.

If the above-described structure is employed, then if the first correlation data and the second correlation data are stored in advance, it is possible for a user to acquire the temperature dependence of the spectral characteristics of the substrate simply by inputting the electrical resistivity of the substrate (or the impurity concentration thereof). As a result, even if information about the temperature dependence of the spectral characteristics of the substrate has not been prepared in advance, a user is able to easily acquire that information.

A structure in which the radiation temperature measurement device of the present invention is a device that measures a temperature of the measurement target when this is housed within a chamber may also be considered. In the case of this structure, a discrepancy is generated in the radiation temperature due to the effects of the chamber.

In order to solve this problem, it is preferable that the radiation temperature measurement device measure a temperature of the measurement target that is housed within a chamber, and that the temperature calculation unit correct the temperature of the measurement target using temperature correction parameters originating in the chamber.

As a specific aspect of the radiation temperature measurement device that is used to cancel out any effects from infrared radiation that has been transmitted from the rear side of the measurement target, it is desirable that, in this radiation temperature measurement device, the infrared detection unit be provided with a first infrared detection unit and a second infrared detection unit that detect infrared radiation from the measurement target in each of a first detection infrared wavelength band and a second detection infrared wavelength band which are mutually different wavelength bands, and that the temperature calculation unit calculate the temperature of the measurement target based on the respective infrared radiation amounts detected by the respective infrared detection units.

In order to make the structure of the radiation temperature measurement device more compact, it is preferable that an optical system that condenses infrared radiation emitted from the measurement target be used in common by both the first infrared detection unit and the second infrared detection unit.

As a specific aspect of the radiation temperature measurement device, it is desirable that the substrate be a wafer formed from a monocrystalline material, and that the thin film contain an $SiO_2$ film or an $SiN$ film.

A radiation temperature measurement method of the present invention is a method in which a temperature of a measurement target having a substrate and a thin film which is formed on a surface of that substrate is measured, and is characterized in that an amount of infrared radiation emitted from the measurement target is detected, substrate spectral characteristics data showing a temperature dependence of spectral characteristics of the substrate are stored, inputs of individual spectral characteristics data showing information relating to a reflectivity and transmissivity at a predetermined temperature of the measurement target are received, the temperature dependence of the spectral characteristics of the measurement target are calculated based on the substrate spectral characteristics data and the individual spectral characteristics data, and the temperature of the measurement target is calculated based on the detected amount of infrared radiation and on the calculated temperature dependence of the spectral characteristics of the measurement target.

A program for a radiation temperature measurement device of the present invention is a program for a radiation temperature measurement device that measures a temperature of a measurement target having a substrate and a thin film which is formed on a surface of that substrate, and is characterized by enabling a computer to function as an infrared detection unit that detects an amount of infrared radiation emitted from the measurement target, a substrate spectral characteristics data storage unit in which substrate spectral characteristics data showing a temperature dependence of the spectral characteristics of the substrate is stored, an individual spectral characteristics data receiving unit that receives inputs of individual spectral characteristics data showing information relating to a reflectivity and transmissivity at a predetermined temperature of the measurement target, a spectral characteristics calculation unit that calculates the temperature dependence of the spectral characteristics of the measurement target based on the substrate spectral characteristics data and the individual spectral characteristics data, and a temperature calculation unit that calculates the temperature of the measurement target based on the amount of infrared radiation detected by the infrared detection unit and on the temperature dependence of the spectral characteristics of the measurement target calculated by the spectral characteristics calculation unit.

According to the above-described radiation temperature measurement method and program for a radiation temperature measurement device, it is possible to obtain the same type of effects as those obtained from the above-described radiation temperature measurement device of the present invention.

[Effects of the Invention]

According to the present invention which is formed in the manner described above, in a radiation temperature measurement device that measures a temperature of a measurement target in which a thin film is formed on a surface of a substrate, prior to performing a temperature measurement, it is possible to shorten the time required to obtain a temperature dependence of spectral characteristics of the measurement target.

[Brief Description of the Drawings]

[FIG. 1] FIG. 1 is a view schematically showing an overall structure of a radiation temperature measurement device of the present embodiment.

[FIG. 2] FIG. 2 is a view schematically showing a structure of an infrared detection unit of the same embodiment.

[FIG. 3] FIG. 3 is a function block diagram of the radiation temperature measurement device of the same embodiment.

[FIG. 4] FIG. 4 is a view schematically showing a structure of an individual spectral characteristics measurement unit of the same embodiment.

[FIG. 5] FIG. 5 shows an example of a relationship between an electrical resistivity, a refractive index, and a temperature of a substrate.

[FIG. 6] FIG. 6 shows an example of a relationship between an electrical resistivity, an extinction coefficient, and a temperature of a substrate.

[FIG. 7] FIG. 7 is a view illustrating a reflectivity and a transmissivity of light in a measurement target of the same embodiment.

[FIG. 8] FIG. 8 is a function block diagram of a radiation temperature measurement device of a variant embodiment.

[FIG. 9] FIG. 9 is a function block diagram of a radiation temperature measurement device of a variant embodiment.

[FIG. 10] FIG. 10 is a view schematically showing a structure of an infrared detection unit of a variant embodiment.

[FIG. 11] FIG. 11 is a view schematically showing a structure of an infrared detection unit of a variant embodiment.

[FIG. 12] FIG. 12 is a view illustrating a measurement method of an individual spectral characteristics measurement unit of a variant embodiment.

[FIG. 13] FIG. 13 is a view illustrating a calculation principle of a temperature calculation unit of an embodiment of the present invention.

[FIG. 14] FIG. 14 is a view illustrating a calculation principle of a temperature calculation unit of an embodiment of the present invention.

[FIG. 15] FIG. 15 is a view illustrating a calculation principle of a temperature calculation unit of an embodiment of the present invention.

[Best Embodiments for Implementing the Invention]

Hereinafter, an embodiment of the radiation temperature measurement device of the present invention will be described with reference to the drawings.

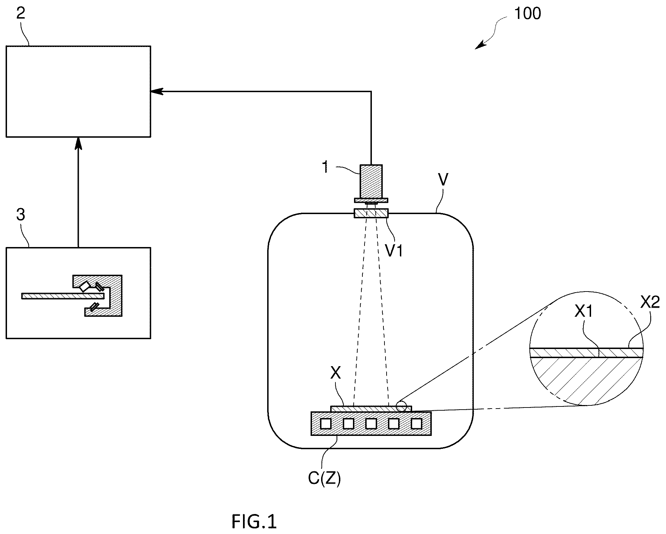

A radiation temperature measurement device 100 of the present embodiment is used by being incorporated into a semiconductor manufacturing system that manufactures, for example, a semiconductor wafer X. This radiation temperature measurement device 100 performs a non-contact measurement of the temperature of the semiconductor wafer X, which is serving as the measurement target, and, as is shown in FIG. 1, is a non-contact type of measurement device that is provided with an infrared detection unit 1 that detects infrared radiation emitted from the semiconductor wafer X, and with a calculation device 2 that calculates a temperature of the semiconductor wafer X based on the amount of infrared radiation detected by the infrared detection unit 1. In this embodiment, the semiconductor wafer X is fixed in a predetermined position within a processing chamber V using an electrostatic chuck device C. The radiation temperature measurement device 100 is formed such that the temperature of the semiconductor wafer X is measured through a measurement window V1 that is formed in a wall of the processing chamber V and through which infrared radiation is transmitted. Note that processing such as, for example, film formation, etching, washing, surface modification, heating, or cooling or the like is performed in the processing chamber V.

Prior to giving a detailed description of the structure of this radiation temperature measurement device 100, firstly, a description of the semiconductor wafer X that is serving as the measurement target will be given.

In this semiconductor wafer X, it is also possible for infrared radiation to be transmitted through the measurement target from an object (i.e., a non-measurement target Z) which is located in the background and has a lower emissivity (i.e., a higher transmissivity) in an infrared wavelength band capable of being detected by the infrared detection unit 1 (hereinafter, referred to as an detection infrared wavelength band), and to then enter a sensor element 11 provided in the infrared detection unit 1. More specifically, this semiconductor wafer X is provided with a circular, thin-plate shaped substrate X1 (i.e., an Si substrate) that is formed from monocrystalline silicon, and a thin film X2 in the form of, for example, a silicon dioxide ($SiO_2$) or silicon nitride (SiN) or the like dielectric film that is formed, i.e., deposited on the surface of the substrate X1. The thin film X2 may be formed by a single layer, or may have a multilayer structure made up of mutually different layers. The thickness of the thin film X2 is preferably a thickness that allows infrared radiation to be transmitted therethrough and a thickness of, for example, 500 nm or less (for example, 400 nm) is preferred, however, the present invention is not limited to this. The semiconductor wafer X is disposed such that the one particular surface of the substrate X1 on which the thin film X2 is formed faces towards the measurement window V1 of the processing chamber V, while the rear surface thereof faces towards a flat, adhesive surface that is provided on the electrostatic chuck device C. In the present embodiment, the electrostatic chuck device C that is provided on the rear surface side of the semiconductor wafer X serves as the non-measurement target Z.

Next, the respective portions of the radiation temperature measurement device 100 will be described.

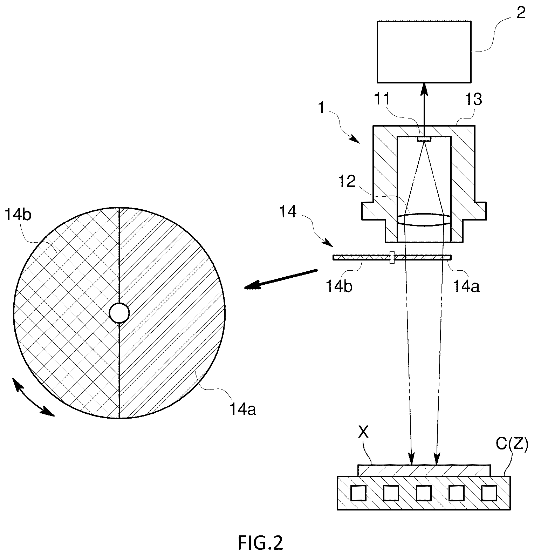

As is shown in FIG. 2, the infrared detection unit 1 is provided with the sensor element 11 such as a thermopile or the like that is capable of detecting infrared radiation, an optical system 12 that is disposed in front of the sensor element 11, and a housing 13 that contains the sensor element 11 and the optical system 12. The infrared detection unit 1 is disposed so as to face the surface of the semiconductor wafer X (more specifically, the surface of the thin film X2), and is formed so as to be able to receive infrared radiation from the semiconductor wafer X.

The sensor element 11 is a thermal type of element that detects a change in temperature as a result of infrared radiation absorption as a change in electromotive force. Here, a thermopile in which a plurality of thermocouples are arranged in series so as to form a thin film is used. Note that it is also possible for another type of thermal sensor such as a bolometer or a current collection type of sensor to be used as the sensor element 11 or, alternatively, for a nonthermal type such as a quantum type of sensor to be used.

The optical system 12 is formed by a lens or the like that is disposed in front of the sensor element 11. This lens is an IR lens that condenses infrared radiation emitted from the semiconductor wafer X onto the sensor element 11 and, when looked at in plan view, may be formed by a substantially circular lens having a diameter of, for example, 10 mm ~ 22 mm. Note that the shape and size of the lens are not limited to those described above, and may be altered as is appropriate.

Furthermore, in the infrared detection unit 1 of the present embodiment, a wavelength selection mechanism 14 that selects a wavelength band of the infrared radiation received in the sensor element 11 is provided either in front of or after the optical system 12. This wavelength selection mechanism 14 is provided with a plurality of optical filters 14a and 14b that respectively transmit mutually different infrared wavelength bands, and a moving mechanism that selectively moves either of the optical filters 14a or 14b onto an optical path. By switching between the optical filters 14a and 14b, the wavelength selection mechanism 14 is able to cause the infrared detection unit 1 to function as a plurality of infrared detection units 1 (hereinafter, these may be referred to as a first infrared detection unit 1a and a second infrared detection unit 1b) that detect mutually different detection infrared wavelength bands (i.e., a first detection infrared wavelength band and a second detection infrared wavelength band) as the detectable wavelength bands. By employing this structure, the optical system 12 and the housing 13 can be used in common by the plurality of infrared detection units 1a and 1b. Here, the term "mutually different" includes wavelength bands that partially overlap each other. In other words, as long as the wavelength bands are not exactly the same, then they may be considered mutually different. In the present embodiment, the first detection infrared wavelength band is between not less than 7 μm and not more than 9 μm, while the second detection infrared wavelength band is between not less than 8 μm and not more than 14 μm, however, the present invention is not limited to this.

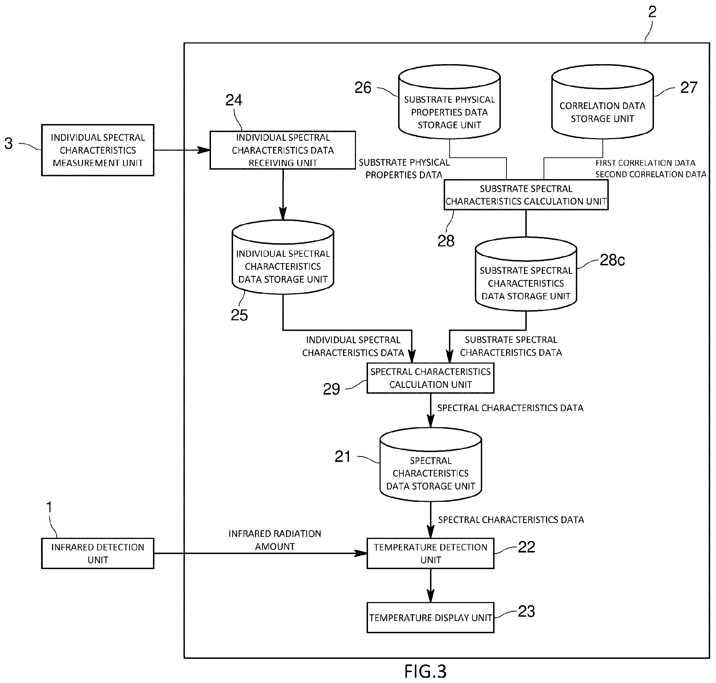

The calculation device 2 is a dedicated or general-purpose computer that is provided with a CPU, internal memory, input/output interfaces, and A/D converters and the like. As a result of the CPU and peripheral devices thereof operating in mutual collaboration in accordance with a predetermined program stored in the internal memory, as is shown in FIG. 3, the calculation device performs the functions at least of a spectral characteristics data storage unit 21, a temperature calculation unit 22, and a temperature display unit 23.

In the spectral characteristics data storage unit 21 is stored spectral characteristics data which shows a temperature dependence (i.e., shows a change in the spectral characteristics that corresponds to a change in temperature, in other words, the spectral characteristics at each temperature: may also be referred to as 'temperature dependence) of the spectral characteristics (i.e., characteristics showing an energy ratio at each wavelength between the transmissivity, reflectivity, and emissivity: may also be referred to as 'spectral distribution') of the semiconductor wafer X.

The temperature calculation unit 22 performs at least a function of calculating the temperature of the semiconductor wafer X based on a value of a detection signal output from the sensor element 11, and on spectral characteristics data stored in the spectral characteristics data storage unit 21. A temperature calculated by this temperature calculation unit 22 is output as a temperature signal.

The temperature display unit 23 is provided with a display monitor or the like. The temperature display unit 23 receives the aforementioned temperature signal and displays the temperature on the display monitor. Note that it is not necessary that the temperature calculation unit 22 and the temperature display unit 23 be located in the vicinity of the infrared detection unit 1, and as long as they are connected thereto either by means of a cable or wirelessly, then they may be sited in any suitable desired location. In addition, it is also possible to provide a temperature control device (not shown in the drawings) that receives the aforementioned temperature signals and performs temperature control of the measurement target, so as to form a temperature measurement control system using this temperature control device and the above-described radiation temperature measurement device 100.

Next, an example of a method used to calculate the temperature of the semiconductor wafer X performed using this temperature calculation unit 22 will be described in detail.

The temperature calculation unit 22 calculates the temperature of the semiconductor wafer X based on the values of detection signals (i.e., a first amount of infrared radiation and a second amount of infrared radiation) output respectively from the first infrared detection unit 1a and the second infrared detection unit 1b, and on the spectral characteristics of the semiconductor wafer X shown by the spectral characteristics data.

The calculation principle thereof is described below.

An overall amount of infrared radiation in a predetermined wavelength band that enters the respective infrared detection units 1 is the sum of infrared radiation A1 which is infrared radiation from the semiconductor wafer X, infrared radiation A2 which is infrared radiation from the background thereof, and infrared radiation A3 which is infrared radiation reflected by the semiconductor wafer X. In a case in which the radiation temperature measurement device 100 and the semiconductor wafer X are directly facing each other, then A3 is the infrared radiation from the radiation temperature measurement device 100 and, therefore, is known. Accordingly, a ratio R between A1 and A2, which is R = A1/A2, corresponds to the emissivity/transmissivity of the semiconductor wafer X. This ratio R is stored in advance in the spectral characteristic data storage unit 21.

As a consequence, the target temperature of a measurement is calculated using simultaneous equations or a bisection method from data from two mutually different wavelength bands, in other words, from a first infrared detection amount and a second infrared detection amount, and from the known ratios R1 and R2 in the respective wavelength bands.

Next, a detailed example of a calculation will be given.

If a spectral radiant energy from the semiconductor wafer X detected by the first infrared detection unit 1a is taken as $E_1$ (Tx), a spectral radiant energy from the background of the semiconductor wafer X detected by the first infrared detection unit 1a is taken as $E_1$ (Tb), a spectral radiant energy from the semiconductor wafer X detected by the second infrared detection unit 1b is taken as $E_2$ (Tx), and a spectral radiant energy from the background of the semiconductor wafer X detected by the second infrared detection unit 1b is taken as $E_2$ (Tb), then a spectral radiant energy (i.e., a first infrared detection amount) $W_1$ detected by the first infrared detection unit 1a is determined as:

$$W_1 = R_1 \cdot E_1 \ (Tx) + (1\text{-}R_1) \cdot E_1 \ (Tb) \qquad \dots (1)$$

Moreover, a spectral radiant energy $W_2$ detected by the second infrared detection unit 1b is determined as:

$$W_2 = R_2 \cdot E_2 \ (Tx) + (1\text{-}R_2) \cdot E_2 \ (Tb) \qquad \dots (2)$$

Here, the respective detection infrared wavelength bands are set such that R1 ≠ R2, and because there are two unknown quantities, namely, a temperature Tx of the semiconductor wafer X and a disturbance temperature Tb, by employing the foregoing Equations (1) and (2), the following Equation (3) can be established:

$$E_1^{-1} \ [\{W_1 - R_1 \cdot E_1 \ (T_x)\} \ / \ (1\text{-}R_1)] = E_2^{-1} \ [\{W_2 - R_2 \cdot E_2 \ (Tx)\} \ / \ (1\text{-}R_2)]$$

$$\dots (3)$$

The temperature calculation unit 23 calculates the temperature of the semiconductor wafer X based on the above Equation (3). Because a relationship E (T) between the spectral radiant energy and the temperature increases monotonically, due to there being only one solution that satisfies equation (3), it is possible to determine the target temperature Tx.

According to the radiation temperature measurement device 100 having the structure described above, even if the non-measurement target Z which emits infrared radiation that is transmitted through the range of the measurement field is present in the background of the measurement target X and, moreover, the temperature of this non-measurement target Z changes, it is still possible to eliminate any effects arising therefrom.

Moreover, the radiation temperature measurement device 100 of the present embodiment is formed so as to be additionally provided with an individual spectral characteristics measurement unit 3 that, in order to shorten the time required to perform the task of acquiring the temperature dependence of the spectral characteristics of the semiconductor wafer X, measures the transmissivity t and reflectivity r of the semiconductor wafer X at a predetermined temperature, and is formed such that the calculation device 2 is able to additionally function as an individual spectral characteristics data receiving unit 24, an individual spectral characteristics data storage unit 25, a substrate physical property data storage unit 26, a correlation data storage unit 27, a substrate spectral characteristics calculation unit 28, a substrate spectral characteristics data storage unit 28c, and a spectral characteristics calculation unit 29.

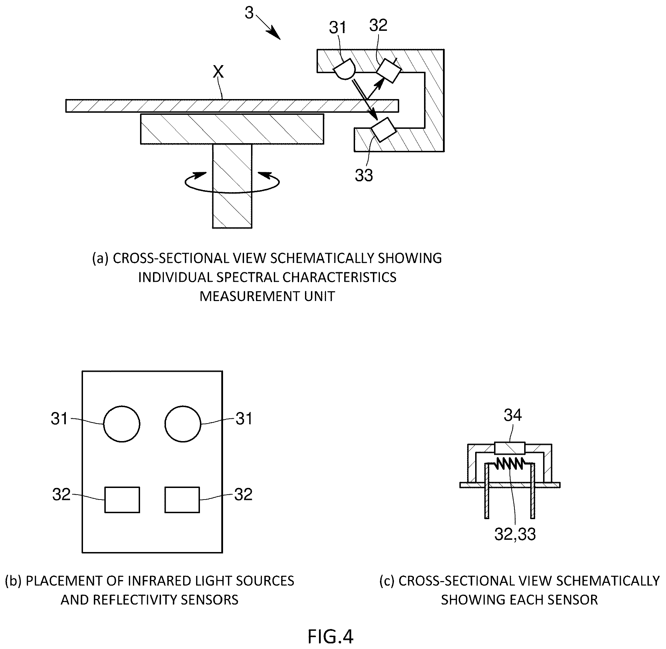

As is shown in FIG. 1, the individual spectral characteristics measurement unit 3 is disposed separately from the processing chamber V and measures the transmissivity t and reflectivity r of the semiconductor wafer X prior to this semiconductor wafer X being transported into the processing chamber V. More specifically, as is shown in FIG. 4, this individual spectral characteristics measurement unit 3 is provided with an infrared light source 31 that irradiates infrared radiation of a predetermined wavelength range onto the semiconductor wafer X, a reflectivity sensor 32 that detects infrared radiation reflected by the semiconductor wafer X, a transmissivity sensor 33 that detects infrared radiation transmitted through the semiconductor wafer X, and a temperature adjustment mechanism that adjusts the temperature of the semiconductor wafer X.

Two infrared light sources 31 are provided so as to individually correspond to the first infrared detection unit 1a and the second infrared detection unit 1b. In the present embodiment, each infrared light source 31 irradiates infrared radiation in a wavelength range that includes both detection wavelength ranges of the two infrared detection units 1. Note that it is also possible for one infrared light source 31 to irradiate either all of, or a portion of the infrared radiation of the detection wavelength range of one infrared detection unit 1 (i.e., the first detection infrared wavelength band), and for the other infrared light source 31 to irradiate either all of, or a portion of the infrared radiation of the detection wavelength range of the other infrared detection unit 1 (i.e., the second detection infrared wavelength band).

In addition, two each of both the reflectivity sensor 32 and the transmissivity sensor 33 are also provided so as to correspond to the two infrared detection units 1. One reflectivity sensor 32 and transmissivity sensor 33 detect infrared radiation from one infrared light source 31, while the other reflectivity sensor 32 and transmissivity sensor 33 detect infrared radiation from the other infrared light source 31. Here, a filter 34 that transmits infrared radiation of the detection wavelength range of each infrared detection unit 1 is provided in front of the reflectivity sensor 32 and transmissivity sensor 33.

The temperature adjustment mechanism is disposed so as to face towards the surface of the semiconductor wafer X, and is able to adjust the temperature of the semiconductor wafer X to a desired fixed temperature (i.e., ambient temperature). The temperature adjustment mechanism of the present embodiment is set so as to make the surface of the semiconductor wafer X approximately 29 °C (which is the aforementioned predetermined temperature), however, it may also be able to raise the temperature thereof to a high temperature such as, for example, 200 °C or the like.

Detection signals from the respective reflectivity sensors 32 and the respective transmissivity sensors 33, in other words, detection signals showing the transmissivity t and reflectivity r in each detection wavelength range at the set temperature (approximately 29 °C) are output as individual spectral characteristics data to the individual spectral characteristics data receiving unit 24, and are then stored in the individual spectral characteristics data storage unit 25.

The substrate physical property data storage unit 26 stores substrate physical property data which shows information relating to the physical properties of the substrate X1 used to form the semiconductor wafer X. The substrate physical property data includes, at the least, information relating to an electrical resistivity ($\Omega \cdot$ cm) and thickness (mm) of the substrate X1 and, in addition to this, may also include information relating to an impurity concentration and the like thereof. This substrate physical property data is input in advance by a user prior to the measurement of the radiation temperature.

The correlation data storage unit 27 stores first correlation data showing a correlation between the electrical resistivity (or impurity concentration), temperature, and refractive index of the substrate X1, and second correlation data showing a correlation between the electrical resistivity (or impurity concentration), temperature, and an extinction coefficient of the substrate X1. The first correlation data and the second correlation data are all determined via experiment, and are stored in advance in the correlation data storage unit 27 prior to the measurement of the radiation temperature.

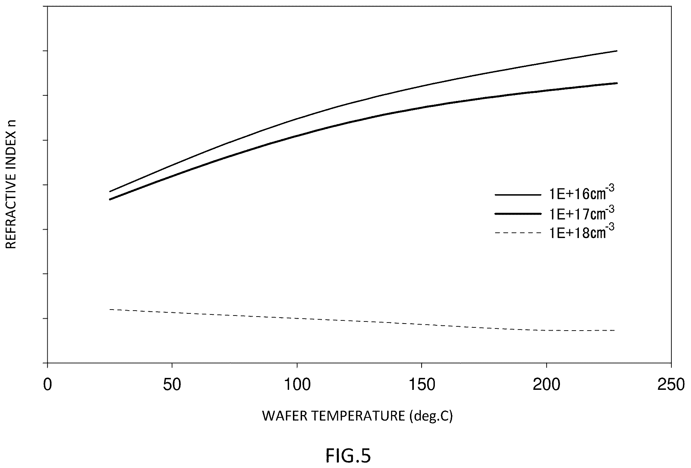

A correlation shown by the first correlation data may be, for example, a calculation model (in other words, a function that takes a temperature and an electrical resistivity as variables) for calculating the refractive index of the substrate X1 from the temperature and electrical resistivity (or impurity concentration) of the substrate X1, or may be a machine learning model that employs machine learning to calculate a correlation between the temperature and electrical resistivity of the substrate X1 and the refractive index of the substrate X1. Correlations shown by this first correlation data are calculated in advance based on an enormous number of data items (shown as an example in FIG. 5) obtained by, for example, preparing an enormous number of samples having mutually different electrical resistivities (or impurity concentrations), and then measuring the refractive indexes thereof at a plurality of temperatures.

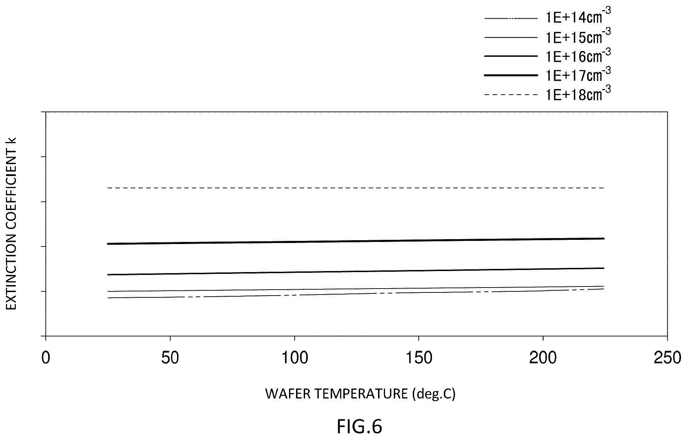

A correlation shown by the second correlation data may be, for example, a calculation model (in other words, a function that takes a temperature and an electrical resistivity as variables) for calculating the extinction coefficient of the substrate X1 from the temperature and electrical resistivity (or impurity concentration) of the substrate X1, or may be a machine learning model that employs machine learning to calculate a correlation between the temperature and electrical resistivity of the substrate X1 and the extinction coefficient of the substrate X1. Correlations shown by this second correlation data are calculated in advance based on an enormous number of data items (shown as an example in FIG. 6) obtained by, for example, preparing an enormous number of samples having mutually different electrical resistivities (or impurity concentrations), and then measuring the extinction coefficients thereof at a plurality of temperatures.

The substrate spectral characteristics calculation unit 28 calculates substrate spectral characteristics data that shows the temperature dependence of the spectral characteristics of the substrate X1 itself by performing a mathematical operation based on the substrate physical property data stored in the substrate physical property data storage unit 26, and on the respective correlation data stored in the correlation data storage unit 27.

The spectral characteristics calculation unit 29 calculates spectral characteristics data that shows the temperature dependence of the spectral characteristics of the semiconductor wafer X by performing a mathematical operation based on the individual spectral characteristics data stored in the individual spectral characteristics data storage unit 25, and on the substrate spectral characteristics data stored in the substrate spectral characteristics data storage unit 28c.

More specifically, the substrate spectral characteristics calculation unit 28 calculates the temperature dependence of the spectral characteristics of the substrate X1 itself using information relating to the physical properties of the substrate X1 (specifically, the electrical resistivity and the thickness thereof) shown by the substrate physical properties data, a correlation shown by the first correlation data, and a correlation shown by the second correlation data. In addition, the spectral characteristics calculation unit 29 calculates information relating to the thin film X2 using the temperature dependence of the spectral characteristics of the substrate X1 calculated by the substrate spectral characteristics calculation unit 28, and using the transmissivity t and reflectivity r of the semiconductor wafer X at a predetermined temperature which is shown by the individual spectral characteristics data. This information relating to the thin film X2 is information relating to the reflectivity and transmissivity at the boundary face between the thin film X2 and the atmosphere at that particular predetermined temperature. The spectral characteristics calculation unit 29 then calculates the temperature dependence of the spectral characteristics of the semiconductor wafer X using the calculated information relating to the thin film X2 at the predetermined temperature, and the spectral characteristics at each temperature of the substrate X1 itself that are stored in the substrate spectral characteristics data storage unit 28c.

Hereinafter, a specific example of a calculation of the temperature dependence of the spectral characteristics of the semiconductor wafer X will be described.

(Step 1) Calculation of the Temperature Dependence of the Spectral Characteristics of the Substrate X1

The substrate spectral characteristics calculation unit 28 calculates the temperature dependence of the spectral characteristics (including, at the least, characteristics showing the energy ratio at each wavelength of the transmissivity and reflectivity) of the substrate X1 itself using information relating to the physical properties of the substrate X1 (specifically, the electrical resistivity and the thickness thereof) shown by the substrate physical properties data, correlations shown by the first correlation data and the second correlation data, and the following Equations (4) to (6).

$$T_i = e^{-4\pi kd/\lambda} \qquad \ldots (4)$$

$$R_0 = \{n_0 - (n^2 + k^2)^{\frac{1}{2}}\}^2 / \{n_0 + (n^2 + k^2)^{\frac{1}{2}}\}^2 \qquad \ldots (5)$$

$$T_0 = 1 - R_0 \qquad \ldots (6)$$

Here,

$T_i$ : transmissivity of the substrate X1,
$R_0$ : reflectivity at the boundary face between the substrate X1 and the atmosphere,
$T_0$ : transmissivity at the boundary face between the substrate X1 and the atmosphere,
k : extinction coefficient of the substrate X1,
d : wafer thickness (m),
$\lambda$ : wavelength (m),
n : refractive index of the substrate X1, and
$n_0$ : refractive index of the atmosphere.

More specifically, the substrate spectral characteristics calculation unit 28 calculates the spectral characteristics of the substrate X1 itself by applying the electrical resistivity of the substrate X1 to correlations shown by the first correlation data and the second correlation data, and then calculating the extinction coefficient k and refractive index n of the substrate X1, and then applying the calculated extinction coefficient k, refractive index n, and thickness of the substrate X1 to the Equations (4) to (6) given above. The substrate spectral characteristics calculation unit 28 calculates the temperature dependence of the spectral characteristics of the substrate X1 by performing the foregoing calculations for each of a plurality of temperatures. The calculated substrate spectral characteristics data showing the temperature dependence of the spectral characteristics of the substrate X1 is then stored in the substrate spectral characteristics data storage unit 28c.

(Step 2) Calculation of the Information Relating to the Thin Film X2

Next, the spectral characteristics calculation unit 29 calculates the information relating to the thin film X2 using the temperature dependence of the spectral characteristics of the substrate X1 shown by the substrate spectral characteristics data, and using the transmissivity t and reflectivity r of the semiconductor wafer X at a predetermined temperature which is shown by the individual spectral characteristics data. The information relating to the thin film X2 that is calculated here is a reflectivity $R_f$ at the boundary face between the surface of the semiconductor wafer X as seen from the atmosphere side (i.e., the surface of the thin film X2) and the atmosphere at a predetermined temperature, and a transmissivity $T_f$ at the boundary face between the surface of the semiconductor wafer X as seen from the atmosphere side and the atmosphere at that predetermined temperature.

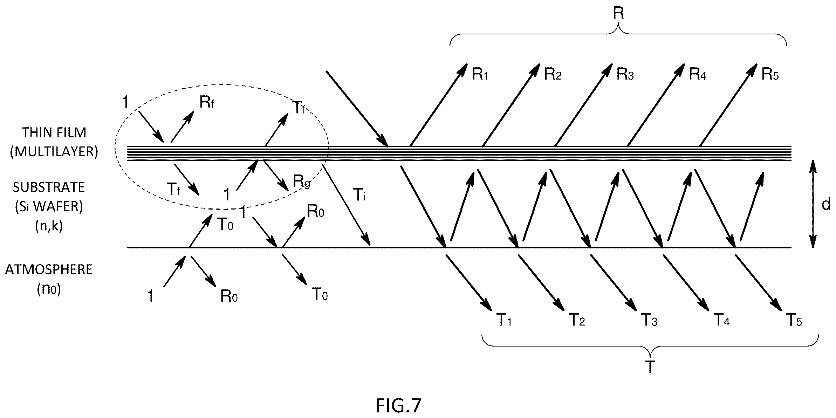

A specific example of this calculation will now be given. As is shown in FIG. 7, if:

a reflectivity at the boundary face between the surface of the semiconductor wafer X as seen from the atmosphere side (i.e., the surface of the thin film X2) and the atmosphere is taken as $R_f$;
a reflectivity at the boundary face between the surface of the semiconductor wafer X as seen from the substrate X1 side and the atmosphere is taken as $R_9$; and
a transmissivity at the boundary face between the surface of the semiconductor wafer X as seen from the atmosphere side and the atmosphere is taken as $T_f$, then
a sum R of the reflection components obtained from multiple reflections at the substrate X1 boundary face (in other words, the reflectivity of the semiconductor wafer X), and a sum T of the transmissivity components obtained from multiple reflections at the substrate X1 boundary face (in other words, the transmissivity of the semiconductor wafer X) are found using the following Equations (7) and (8).

$$R = \Sigma R_j$$
$$= R_f + T_f^2 T_i^2 R_0 \left(1 + T_i^2 R_0 R_9 + T_i^4 R_0^2 R_9^2 + T_i^6 R_0^3 R_9^3 + \ldots\right)$$
$$= R_f + T_f^2 T_i^2 R_0 / (1 - T_i^2 R_0 R_9) \qquad \ldots (7)$$

$$T = \Sigma T_j$$
$$= T_0 T_f T_i \left(1 + T_i^2 R_0 R_9 + T_i^4 R_0^2 R_9^2 + T_i^6 R_0^3 R_9^3 + \ldots\right)$$
$$= T_0 T_f T_i / (1 - T_i^2 R_0 R_9) \qquad \ldots (8)$$

By then solving these Equations (7) and (8) for $R_f$ and $T_f$, the following Equations (9) and (10) are obtained.

$$R_f = (R T_0^2 - T^2 R_0) / (T_0^2 - T^2 R_0^2 T_i^2) \qquad \ldots (9)$$

$$T_f = (1 - T_i^2 R_0 R_f) T / T_0 T_i \qquad \ldots (10)$$

Here, the reflectivity r and transmissivity t of the semiconductor wafer X at a predetermined temperature that are stored in the individual spectral characteristics data storage unit 25 as individual spectral characteristics data are used for the values for R and T. $T_0$, $R_0$, and $T_i$ are spectral characteristics of the substrate X1 itself, and are calculated in the above-described step 1 after which they are stored in the substrate spectral characteristics data storage unit 28c. The spectral characteristics calculation unit 29 applies the above-described R, T, $T_0$, $R_0$, and $T_i$ at the predetermined temperature to the above Equations (6) and (7) and thereby calculates the reflectivity $R_f$ and the transmissivity $T_f$ of the thin film X2 at the predetermined temperature.

(Step 3) Calculation of the Temperature Dependence of the Spectral Characteristics of the Semiconductor Wafer X

The spectral characteristics calculation unit 29 calculates the temperature dependence of the spectral characteristics of the semiconductor wafer X using the calculated reflectivity $R_0$ and transmissivities $T_0$ and $T_i$ at the respective temperatures of the substrate X1, and using the calculated reflectivity $R_f$ and transmissivity $T_f$ at the predetermined temperatures of the thin film X2. More specifically, the reflectivity R and transmissivity T of the semiconductor wafer X are calculated by applying the calculated information relating to the spectral characteristics of the substrate X1 and the thin film X2 to the above Equations (7) and (8). The temperature dependence of the spectral characteristics of the semiconductor wafer is calculated by performing the foregoing calculations for each of a plurality of temperatures. Here, the information $R_f$ and $T_f$ for the thin film X2 that were calculated in step 2 show the reflectivity and transmissivity of the thin film X2 at a predetermined temperature, however, because the temperature dependence of the spectral characteristics of the thin film X2 itself is extremely small, it may be taken as being the same value at each temperature in the calculations.

Next, a radiation temperature measurement method for measuring a plurality of semiconductor wafers X will be described.

Firstly, a target semiconductor wafer X that is to be measured is transported to a chamber for performing spectral characteristic measurement. The individual spectral characteristics measurement unit 3 provided in this spectral characteristics measurement chamber measures the reflectivity r and transmissivity t at a predetermined temperature of the semiconductor wafer X. Spectral characteristics data showing the measured reflectivity r and transmissivity t is stored in the individual spectral characteristics data storage unit 25. In this way, in the present embodiment, the individual spectral characteristics of the semiconductor wafer X are measured prior to the semiconductor wafer X being transported to the processing chamber V.

Next, a user inputs information relating to the physical properties of the substrate X1 of the semiconductor wafer X (more specifically, the thickness and electrical resistance (or impurity concentration) thereof) into the calculation device 2. The information relating to the physical properties of the substrate X1 that is input is stored in the substrate physical properties data storage unit 26.

The substrate spectral characteristics calculation unit 28 calculates the temperature dependence of the spectral characteristics of the substrate X1 using the substrate physical property information that was input and the plurality of correlation data that was stored in advance. The spectral characteristics calculation unit 29 then calculates the temperature dependence of the spectral characteristics of the semiconductor wafer X using the measured individual spectral characteristics and the calculated substrate spectral characteristics, and stores the results in the spectral characteristics data storage unit 21.

Next, the semiconductor wafer X whose individual spectral characteristics have been measured is transported to the processing chamber V. Here, the first infrared detection unit 1a and the second infrared detection unit 1b detect infrared radiation from the semiconductor wafer X through the measurement window V1 formed in the processing chamber V. The temperature calculation unit 22 then calculates the temperature of the semiconductor wafer X based on the amount of infrared radiation obtained by the respective infrared detection units 1 and on the calculated temperature dependence of the spectral characteristics.

According to the radiation temperature measurement device 100 of the present embodiment that is formed in the manner described above, if a user simply inputs information relating to the physical properties of the substrate X1 such as, for example, the thickness and electrical resistance thereof, and then measures the reflectivity r and transmissivity t of the semiconductor wafer X at a predetermined temperature and also inputs these measurement results, then it is possible to acquire the temperature dependence of the spectral characteristics of the semiconductor wafer X. As a result, it is not necessary to measure the spectral characteristics at a plurality of temperatures of each sample that is made from a different material and has a different film thickness, as is the case conventionally, so that the time required to perform the preliminary preparations necessary when measuring the temperature of a semiconductor wafer X can be considerably shortened.

Note that the present invention is not limited to the above-described embodiment.

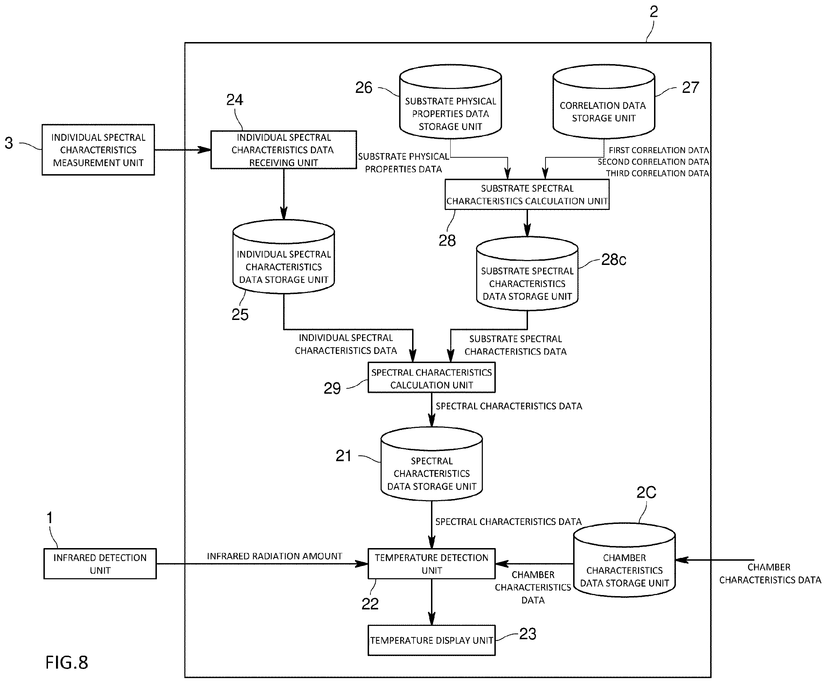

For example, in the radiation temperature measurement device 100 of a variant embodiment, it is also possible for the temperature calculation unit 22 to calculate the temperature of the semiconductor wafer X while taking into account chamber characteristics information, which is information about the characteristics of the processing chamber V in which the semiconductor wafer X is housed. In this case, as is shown in FIG. 8, it is possible for the calculation device 2 to also function as a chamber characteristics data storage unit 2C that stores this chamber characteristics information. The chamber characteristics information is information relating to the temperature correction parameters originating from the processing chamber V, more specifically, the materials forming the surface of parts located in the chamber V (i.e., the reflectivity thereof and the like) and the quantitative ratio of the incident light and the like. This chamber characteristics information is input in advance by a user prior to measurement of the radiation temperature. It is also possible for the temperature calculation unit 22 to match the temperature correction parameters to the calculated spectral characteristic data, and to then calculate the temperature of the semiconductor wafer X using this spectral characteristics data to which the temperature correction parameters have been matched. It is also possible for the temperature calculation unit 22 to calculate the temperature of the semiconductor wafer X using the calculated spectral characteristics data, and to then correct the calculated temperature using the temperature correction parameters.

Moreover, in the radiation temperature measurement device 100 of the variant embodiment, it is also possible for the correlation data storage unit 27 to store third correlation data which shows a correlation between the electrical resistivity (or impurity concentration) and thickness of the substrate and the temperature dependence of the spectral characteristics of the substrate. Correlations shown by this third correlation data are determined by preparing a number of sample substrates having mutually different thicknesses and electrical resistivities, and then measuring the transmissivities and reflectivities of the number of sample substrates at a plurality of mutually different temperatures. The electrical resistivities (or impurity concentrations) and thicknesses of the substrates obtained via these measurements, as well as the massive number of data items showing the temperature dependencies of the spectral characteristics of the corresponding substrates are stored as third correlation data in the correlation data storage unit 27.

In addition, in this variant embodiment, it is also possible to employ for the spectral characteristics calculation unit 29 to be formed so as to calculate the temperature dependence of the spectral characteristics of the substrate X1 itself by applying the information relating to the physical properties of the substrate X1 (i.e., the electrical resistivity and thickness thereof) shown by the substrate physical properties data to the third correlation data.

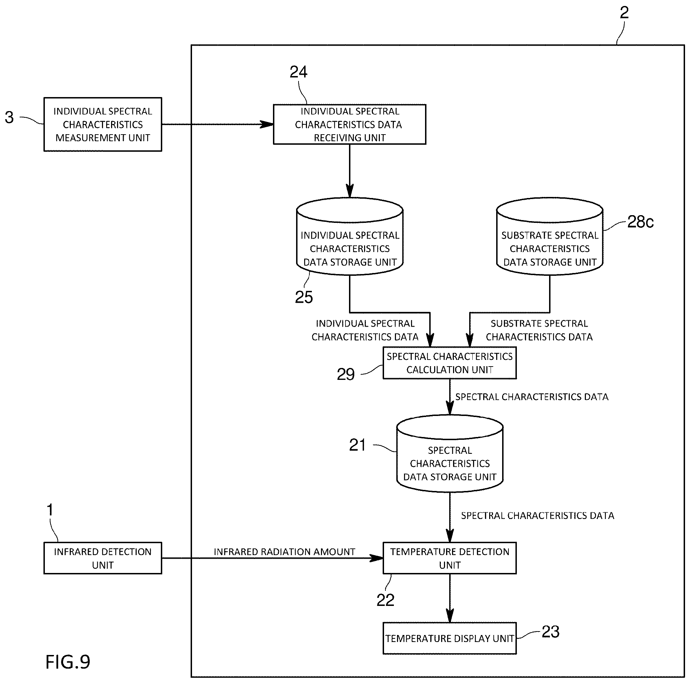

Moreover, the radiation temperature measurement apparatus 100 of the above-described embodiment is formed so as to calculate substrate spectral characteristics, however, the present invention is not limited to this. In a variant embodiment, it is also possible for substrate spectral characteristics data which shows the spectral characteristics of the substrate X1 to be stored in advance in the substrate spectral characteristics data storage unit 28c. In this case, as is shown in FIG. 9, the calculation device 2 performs a portion of, or all of the functions of the substrate physical property data storage unit 26, the correlation data storage unit 27, and the substrate spectral characteristics calculation unit 28.

Moreover, in the radiation temperature measurement device 100 of the variant embodiment, it is also possible for the first correlation data to show correlations between the electrical resistivity (or impurity concentration), the temperature, the doping type, and the refractive index of the substrate X1 and, in the same way, for the second correlation data to show correlations between the electrical resistivity (or impurity concentration), the temperature, the doping type, and the extinction coefficient of the substrate X1. The doping type refers to information showing, for example, whether the substrate X1 is a P type or an N type. In this embodiment, it is also possible for the substrate physical property data storage unit 26 to receive from a user information relating to the doping type of the substrate X1, and to store this as substrate physical property data. In addition, it is also possible for the spectral characteristics calculation unit 29 to be formed so as to calculate the reflectivity R and the transmissivity T of the semiconductor wafer X by taking this information relating to the doping type into account in addition to the thickness and electrical resistivity of the substrate X1.

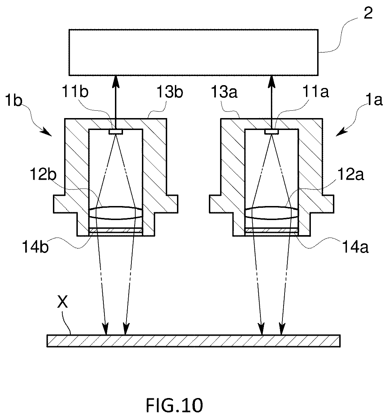

Moreover, the radiation temperature measurement apparatus 100 of the above-described embodiment causes a single infrared detection unit 1 to function as a plurality of infrared detection units 1 (sometimes referred to above as the first infrared detection unit 1a and the second infrared detection unit 1b) having mutually different detection infrared wavelength bands as the bands that each unit is able to detect by using the wavelength selection mechanism 14, however, the present invention is not limited to this. As is shown in FIG. 10, the radiation temperature measurement apparatus 100 of the variant embodiment may be provided with the pair of infrared detection units 1a and 1b which are physically different from each other, and with optical filters 14a and 14b that transmit mutually different infrared wavelength bands and are disposed either in front of, or behind the respective optical systems 12a and 12b of the infrared detection units 1a and 1b. As a result, a structure is created in which the detection infrared wavelength bands (i.e., a first detection infrared wavelength band and a second detection infrared wavelength band), which are the wavelength bands that are detectable by the respective infrared detection units 1a and 1b, are mutually different from each other.

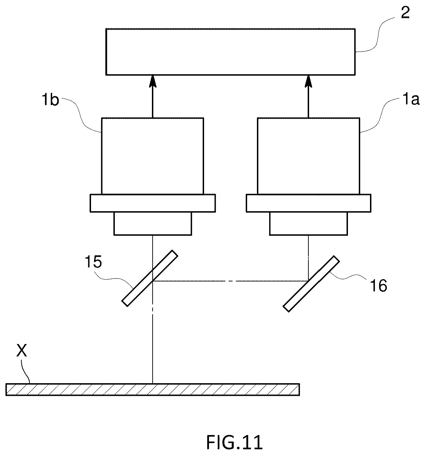

Furthermore, as is shown in FIG. 11, for example, in the radiation temperature measurement device 100 of the variant embodiment, it is also possible to provide a beam splitter 15 so that the infrared radiation from the measurement target X is split into two beams with one beam being introduced respectively into each of the infrared detection units 1a and 1b. Note that the symbol 16 denotes a mirror. If this type of structure is employed, then it becomes possible to perform measurements in a shorter period of time than when the wavelength selection mechanism 14 that is able to switch between the above-described plurality of optical filters 14a and 14b is used.

The measurement target of the above-described embodiment is a material in which $R1 \neq R2$ and, provided that it is possible for the thin film X2 to be formed on a surface thereof, is not limited to being the semiconductor wafer X.

Moreover, the radiation temperature measurement device 100 of the above-described embodiment is incorporated into a semiconductor manufacturing system, however, it may also be a stand-alone structure that is not incorporated into a semiconductor manufacturing system.

In the above-described embodiment, the substrate X1 is a silicon substrate, however, the present invention is not limited to this. In a variant embodiment, provided that the substrate X1 is able to transmit infrared radiation, then it is also possible for the substrate X1 to be a wafer that is used in a semiconductor manufacturing process such as, for example, a monocrystalline Ge (germanium) wafer, or a compound wafer in which the substrate material is formed by a plurality of original elements, or the like.

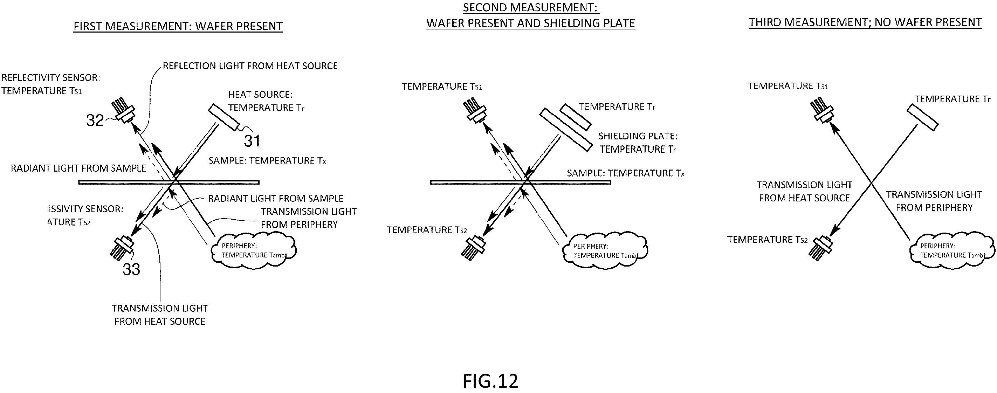

A method of measuring a reflectivity r and transmissivity t of the semiconductor wafer X using the individual spectral characteristics measurement unit 3 of the variant embodiment will now be described. In this measurement method, as is shown in FIG. 12, there are performed (1) a first measurement in which only the semiconductor wafer X is placed between the heat source 31 and the transmissivity sensor 33, and the radiation energy is measured using the respective sensors 32 and 33, (2) a second measurement in which the semiconductor wafer X is placed between the heat source 31 and the transmissivity sensor 33, and a shielding plate is additionally placed between the heat source 31 and the semiconductor wafer X, and the radiation energy is measured using the respective sensors 32 and 33, and (3) a third measurement in which the radiation energy is measured using the respective sensors 32 and 33 without the semiconductor wafer X being placed between the heat source 31 and the transmissivity sensor 33. The reflectivity r and transmissivity t of the semiconductor wafer at a predetermined temperature are then calculated using the measurement values from the respective sensors 32 and 33 obtained by performing the first measurement through the third measurement.

More specifically, the radiation energies $E_1$, $E_3$, and $E_5$ measured by the reflectivity sensor 32, and the radiation energies $E_2$, $E_4$, and $E_6$ measured by the transmissivity sensor 33 in each of the above-described measurements can be expressed using the following Equations (i) to (vi).

First Measurement

$$E_1 = \varepsilon \cdot F_1 (T_x) + t \cdot F_1 (T_{amb}) + r \cdot F_1 (T_r) - F_1 (T_{s1}) \qquad \text{(i)}$$

$$E_2 = \varepsilon \cdot F_2 (T_x) + t \cdot F_2 (T_r) + r \cdot F_2 (T_{amb}) - F_2 (T_{s2}) \qquad \text{(ii)}$$

Second Measurement

$$E_3 = \varepsilon \cdot F_1 (T_x) + t \cdot F_1 (T_{amb}) + r \cdot F_1 (T_{amb}) - F_1 (T_{s1}) \qquad \text{(iii)}$$

$$E_4 = \varepsilon \cdot F_2 (T_x) + t \cdot F_2 (T_{amb}) + r \cdot F_2 (T_{amb}) - F_2 (T_{s2}) \qquad \text{(iv)}$$

Third Measurement

$$E_5 = F_1 (T_{amb}) - F_1 (T_{s1}) \qquad \text{(v)}$$

$$E_6 = F_2 (T_r) - F_2 (T_{s2}) \qquad \text{(vi)}$$

Here, $T_{s1}$ is the temperature of the reflectivity sensor 32, $T_{s2}$ is the temperature of the transmissivity sensor 33, $T_x$ is temperature of the semiconductor wafer, $T_{amb}$ is the ambient temperature, $T_r$ is the temperature of the heat source 31, $\varepsilon$ is the emissivity, r is the reflectivity, and t is the transmissivity.

Here, because a common filter is disposed in front of the reflectivity sensor 32 and the transmissivity sensor 33 so that the sensitivity and offset voltage of the infrared sensors are mutually different, if $F_1 (T) = \alpha \cdot F_2 (T) + \beta$, then the following Equations (vii) through (ix) can be derived from the above Equations (i) through (vi).

$\alpha$ : sensitivity ratio of the infrared sensors
$\beta$ : offset differential voltage of the infrared sensors.

$$E_1 - E_3 = r \cdot \alpha \cdot \{F_2 (T_r) - F_2 (T_{amb}) \} \qquad \text{(vii)}$$

$$E_2 - E_4 = t \cdot \{F_2 (T_r) - F_2 (T_{amb}) \} \qquad \text{(viii)}$$

$$E_6 - E_5 = [F_2 (T_r) - \{\alpha \cdot F_2 (T_{amb}) + \beta\} ] - \{\alpha \cdot F_2 (T_{s1}) + \beta - F_2 (T_{s2})\} \qquad \text{(ix)}$$

The following Equations (x) and (xi) are then derived by then solving the Equations (vii) through (ix) for the reflectivity r and transmissivity t.

$$\text{reflectivity } r = (E_1 - E_3) / \{\alpha \cdot (E_6 - E_5) \} \qquad \text{(x)}$$

$$\text{transmissivity } t = (E_2 - E_4) / (E_6 - E_5) \qquad \text{(xi)}$$

The reflectivity r and the transmissivity t at a predetermined temperature can be calculated by applying the radiation energies $E_1$ to $E_6$ measured by the reflectivity sensor 32 and the transmissivity sensor 33 in the first through third measurements to the Equations (x) and (xi).

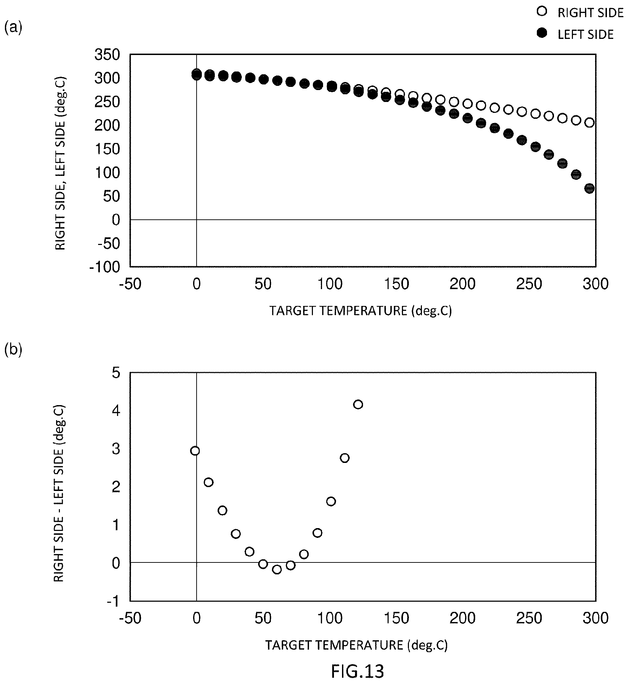

As is described above, in a case in which the temperature calculation unit 22 calculates the temperature Tx of the semiconductor wafer X using a bisection method based on the above Equation (3), depending on the conditions, there may be two solutions that satisfy Equation (3). For example, in a case in which $E_1$ (Tx) ≠ $E_2$ (Tx), and there is only a small difference between $R_1$ and $R_2$, then the right side and left side of Equation (3) may have a relationship such as that in the graph shown in FIG. 13 and, in such cases, there may be two solutions that satisfy Equation (3), namely, Tx = 50°C (Tb = 300°C) and Tx = 75°C (Tb = 290°C). In particular, in a case in which the disturbance temperature Tb is far higher than the temperature Tx of the semiconductor wafer X, there is an increased likelihood of two solutions being possible.

For this reason, after making strenuous investigations, the inventors of the present application discovered that, in conditions in which an absolute value of a maximum value of a difference ($\varepsilon_1$ - $\varepsilon_2$) between an emissivity $\varepsilon_1$ from a measurement target in a first detection infrared wavelength band and an emissivity $\varepsilon_2$ in a second detection infrared wavelength band is not less than 0.4, then irrespective of the size relationship between the temperature Tx of the semiconductor wafer X and the disturbance temperature Tb, and irrespective of the absolute values of the emissivities $\varepsilon_1$ and $\varepsilon_2$ in the respective infrared wavelength bands, there was only one solution that satisfied Equation (3), and it was possible to accurately measure the temperature Tx. More specifically, because the first detection infrared wavelength band is different from the second detection infrared wavelength band, the inclination of the left side of Equation (3) relative to a change in the target temperature Tx is slightly different than the inclination of the right side of Equation (3) relative to the change in the target temperature Tx. In the conditions shown in FIG. 13, in a case in which there is a small difference between the ratio R1 and the ratio R2, when the target temperature is in a range of 0 to 100°C, the difference between the right side inclination and the left side inclination is also small, and because of this, two solutions are also generated. In contrast, if the difference ($\varepsilon_1$ - $\varepsilon_2$) between the emissivity $\varepsilon_1$ from a measurement target in the first detection infrared wavelength band and the emissivity $\varepsilon_2$ in the second detection infrared wavelength band is large, then because it is possible to increase the difference between the right side inclination and the left side inclination relative to the target temperature Tx, it can be considered that there is one solution that satisfies Equation (3).

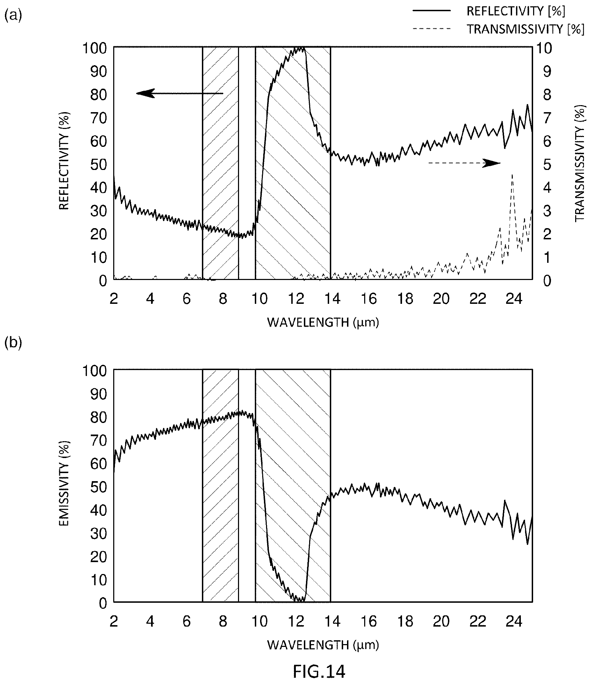

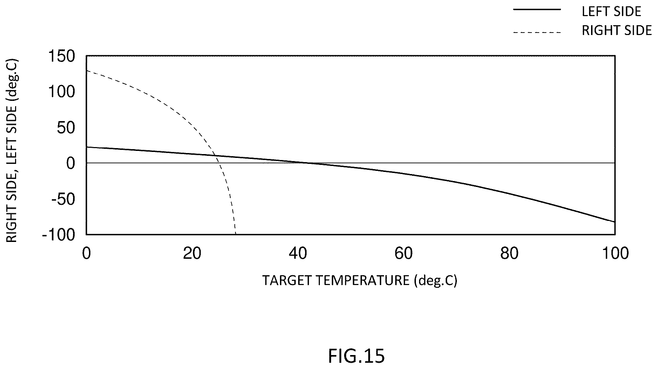

For this reason, in a variant embodiment, it is preferable that the first detection infrared wavelength band, the second detection infrared wavelength band, or the measurement target be selected such that the difference between the emissivity $\varepsilon_1$ from the measurement target in the first detection infrared wavelength band and the emissivity $\varepsilon_2$ in the second detection infrared wavelength band is not less than 0.4, and it is more preferable that these be selected such that this difference is not less than 0.5. For example, as in the above-described embodiment, in a case in which the first detection infrared wavelength band is not less than 7 $\mu$m and not more than 9 $\mu$m, and the second detection infrared wavelength band is not less than 8 $\mu$m and not more than 14 $\mu$m, then if the measurement target is an SiC semiconductor, as is shown in FIG. 14, it was found that the difference between the emissivity $\varepsilon_1$ from the measurement target in the first detection infrared wavelength band and the emissivity $\varepsilon_2$ in the second detection infrared wavelength band is not less than 0.4 and, as is shown in FIG. 15, that one solution satisfied Equation (3) and, even if the disturbance temperature Tb is high, it is still possible to accurately calculate the temperature Tx.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as limited by the foregoing description and is only limited by the scope of the appended claims.

[Industrial Applicability]

In a radiation temperature measurement device that measures a temperature of a measurement target in which a thin film is formed on a surface of a substrate, it is possible to shorten the length of time prior to performing a temperature measurement that is required in order to acquire a temperature dependence of the spectral characteristics of the measurement target.

[Description of the Reference Numerals]

| | |
|---|---|
| 100 | Radiation Temperature Measurement Device |
| 1 | Infrared Detection Unit |
| 22 | Temperature Calculation Unit |
| 24 | Individual Spectral Characteristics Data Receiving Unit |
| 28c | Substrate Spectral Characteristics Data Storage Unit |
| 29 | Spectral Characteristics Calculation Unit |

X       Semiconductor Wafer
X1      Substrate
X2      Thin Film

**Claims**

1.  A radiation temperature measurement device that measures a temperature of a measurement target having a substrate and a thin film which is formed on a surface of that substrate, comprising:

    an infrared detection unit that detects an amount of infrared radiation emitted from the measurement target;
    a substrate spectral characteristics data storage unit in which substrate spectral characteristics data showing a temperature dependence of the spectral characteristics of the substrate is stored;
    an individual spectral characteristics data receiving unit that receives inputs of individual spectral characteristics data showing information relating to a reflectivity and transmissivity at a predetermined temperature of the measurement target;
    a spectral characteristics calculation unit that calculates the temperature dependence of the spectral characteristics of the measurement target based on the substrate spectral characteristics data and the individual spectral characteristics data; and
    a temperature calculation unit that calculates the temperature of the measurement target based on the amount of infrared radiation detected by the infrared detection unit and on the temperature dependence of the spectral characteristics of the measurement target calculated by the spectral characteristics calculation unit.

2.  The radiation temperature measurement device according to Claim 1, wherein the spectral characteristics calculation unit

    calculates the reflectivity and transmissivity at a predetermined temperature of the thin film based on the temperature dependence of the spectral characteristics of the substrate shown by the substrate spectral characteristics data and on the reflectivity and transmissivity of the measurement target at the predetermined temperature shown by the individual spectral characteristics data, and also
    calculates the temperature dependence of the spectral characteristics of the measurement target using the calculated reflectivity and transmissivity at a predetermined temperature of the thin film, and the temperature dependence of the spectral characteristics of the substrate shown by the substrate spectral characteristics data.

3.  The radiation temperature measurement device according to Claim 1 or Claim 2, further comprising:

    a substrate physical property data storage unit that stores substrate physical property data showing information relating to physical properties of the substrate;
    a correlation data storage unit that stores first correlation data showing a correlation between an electrical resistivity, a temperature, and a refractive index of the substrate, and second correlation data showing a correlation between an electrical resistivity, a temperature, and an extinction coefficient of the substrate; and
    a substrate spectral characteristics calculation unit that calculates the temperature dependence of the spectral characteristics of the substrate based on the electrical resistivity of the substrate shown by the substrate physical properties data, a correlation shown by the first correlation data, and a correlation shown by the second correlation data.

4.  The radiation temperature measurement device according to any one of Claim 1 through Claim 3, wherein

    the radiation temperature measurement device measures a temperature of the measurement target that is housed within a chamber, and
    the temperature calculation unit corrects the temperature of the measurement target using temperature correction parameters originating in the chamber.

5.  The radiation temperature measurement device according to any one of Claim 1 through Claim 4, wherein

    the infrared detection unit comprises a first infrared detection unit and a second infrared detection unit that detect infrared radiation from the measurement target in each of a first detection infrared wavelength band and a second detection infrared wavelength band which are mutually different wavelength bands, and
    the temperature calculation unit calculates the temperature of the measurement target based on the respective infrared radiation amounts detected by the respective infrared detection units.

6. The radiation temperature measurement device according to Claim 5, wherein an optical system that condenses infrared radiation emitted from the measurement target is used in common by both the first infrared detection unit and the second infrared detection unit.

7. The radiation temperature measurement device according to any one of Claim 1 through Claim 6, wherein the substrate is a wafer formed from a monocrystalline material, and the thin film contains an $SiO_2$ film or an SiN film.

8. A radiation temperature measurement method in which a temperature of a measurement target having a substrate and a thin film which is formed on a surface of that substrate is measured, and in which

an amount of infrared radiation emitted from the measurement target is detected,
substrate spectral characteristics data showing a temperature dependence of spectral characteristics of the substrate are stored,
inputs of individual spectral characteristics data showing information relating to a reflectivity and transmissivity at a predetermined temperature of the measurement target are received,
the temperature dependence of the spectral characteristics of the measurement target are calculated based on the substrate spectral characteristics data and the individual spectral characteristics data, and
the temperature of the measurement target is calculated based on the detected amount of infrared radiation and on the calculated temperature dependence of the spectral characteristics of the measurement target.

9. A program for a radiation temperature measurement device that measures a temperature of a measurement target having a substrate and a thin film which is formed on a surface of that substrate, and that enables a computer to function as:

an infrared detection unit that detects an amount of infrared radiation emitted from the measurement target;
a substrate spectral characteristics data storage unit in which substrate spectral characteristics data showing a temperature dependence of the spectral characteristics of the substrate is stored;
an individual spectral characteristics data receiving unit that receives inputs of individual spectral characteristics data showing information relating to a reflectivity and transmissivity at a predetermined temperature of the measurement target;
a spectral characteristics calculation unit that calculates the temperature dependence of the spectral characteristics of the measurement target based on the substrate spectral characteristics data and the individual spectral characteristics data; and
a temperature calculation unit that calculates the temperature of the measurement target based on the amount of infrared radiation detected by the infrared detection unit and on the temperature dependence of the spectral characteristics of the measurement target calculated by the spectral characteristics calculation unit.

FIG.1

FIG.2

EP 4 692 742 A1

FIG.3

(a) CROSS-SECTIONAL VIEW SCHEMATICALLY SHOWING
INDIVIDUAL SPECTRAL CHARACTERISTICS
MEASUREMENT UNIT

(b) PLACEMENT OF INFRARED LIGHT SOURCES
AND REFLECTIVITY SENSORS

(c) CROSS-SECTIONAL VIEW SCHEMATICALLY
SHOWING EACH SENSOR

FIG.4

FIG.5

WAFER TEMPERATURE (deg.C)

REFRACTIVE INDEX n

1E+16cm$^{-3}$
1E+17cm$^{-3}$
1E+18cm$^{-3}$

FIG.6

FIG.7

FIG.8

FIG.9

FIG.10

FIG.11

FIG.12

(a)

(b)

FIG.13

FIG.14

FIG.15

## INTERNATIONAL SEARCH REPORT

| International application No. |
|---|
| **PCT/JP2024/010200** |

**A. CLASSIFICATION OF SUBJECT MATTER**

*G01J 5/70*(2022.01)i; *G01J 5/00*(2022.01)i; *G01J 5/60*(2006.01)i; *H01L 21/66*(2006.01)i
FI:  G01J5/70 C; G01J5/00 101C; G01J5/60 E; G01J5/70 Z; H01L21/66 L; H01L21/66 X

According to International Patent Classification (IPC) or to both national classification and IPC

**B. FIELDS SEARCHED**

Minimum documentation searched (classification system followed by classification symbols)

G01J 5/00-5/90; G01K 13/00; H01L 21/203; H01L 21/26-21/268; H01L 21/322-21/326; H01L 21/363; H01L 21/42-21/428; H01L 21/477-21/479; H01L 21/64-21/66

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2022/215417 A1 (HORIBA, LTD.) 13 October 2022 (2022-10-13)<br>paragraphs [0009], [0021]-[0041], [0048], fig. 1-4 | 1, 4-9 |
| A | | 2-3 |
| Y | JP 04-130746 A (HITACHI, LTD.) 01 May 1992 (1992-05-01)<br>page 3, lower left column, lines 11-18, fig. 9-13 | 1, 4-9 |
| A | | 2-3 |
| Y | JP 06-241907 A (TOKAI CARBON CO., LTD.) 02 September 1994 (1994-09-02)<br>paragraph [0018], fig. 1 | 6 |
| A | JP 2002-122480 A (KABUSHIKI KAISHA TOSHIBA) 26 April 2002 (2002-04-26)<br>entire text, fig. 1-12 | 1-9 |
| A | JP 2000-256848 A (CANON KABUSHIKI KAISHA) 19 September 2000 (2000-09-19)<br>entire text, fig. 1-5 | 1-9 |

☑ Further documents are listed in the continuation of Box C.       ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **19 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
|---|
| **PCT/JP2024/010200** |

**C.    DOCUMENTS CONSIDERED TO BE RELEVANT**

| Category* | Citation of document, with indication, where appropriate, of the relevant passages | Relevant to claim No. |
|---|---|---|
| A | JP 2000-121447 A (TOKYO ELECTRON LIMITED) 28 April 2000 (2000-04-28)<br>entire text, fig. 1-9 | 1-9 |
| A | 井内徹, シリコン半導体ウエハのin situ温度計測, 計測と制御, 2008, vol. 47, no. 5, pages 395-402, (IUCHI, Tohru, In Situ Temperature Measurement of Silicon Semiconductor Wafers, Journal of the Society of Instrument and Control Engineers)<br>entire text, fig. 1-13 | 1-9 |
| A | JP 04-069531 A (TOKYO ELECTRON LIMITED) 04 March 1992 (1992-03-04)<br>entire text, fig. 1-2 | 1-9 |
| A | US 4956538 A (TEXAS INSTRUMENTS, INCORPORATED) 11 September 1990 (1990-09-11)<br>entire text, fig. 1-3 | 1-9 |
| A | 渡辺智司 他, 放射温度計による半導体熱処理装置内のウエハ温度計測, 計測自動制御学会論文集, 1989, vol. 25, no. 9, pages 925-931, (WATANABE, Tomoji et al., Radiation Thermometry of Silicon-Wafer in Semiconductor Heat-Treatment Equipment, Transactions of the Society of Instrument and Control Engineers)<br>entire text, fig. 1-9 | 1-9 |

### INTERNATIONAL SEARCH REPORT
Information on patent family members

| International application No. |
|---|
| **PCT/JP2024/010200** |

| Patent document cited in search report | | | Publication date (day/month/year) | Patent family member(s) | | | Publication date (day/month/year) |
|---|---|---|---|---|---|---|---|
| WO | 2022/215417 | A1 | 13 October 2022 | EP | 4303547 | A1 | |
| | | | | paragraphs [0010], [0023]-[0045], [0053], fig. 1-4 | | | |
| JP | 04-130746 | A | 01 May 1992 | (Family: none) | | | |
| JP | 06-241907 | A | 02 September 1994 | (Family: none) | | | |
| JP | 2002-122480 | A | 26 April 2002 | (Family: none) | | | |
| JP | 2000-256848 | A | 19 September 2000 | (Family: none) | | | |
| JP | 2000-121447 | A | 28 April 2000 | US | 6283630 | B1 | |
| JP | 04-069531 | A | 04 March 1992 | (Family: none) | | | |
| US | 4956538 | A | 11 September 1990 | (Family: none) | | | |

Form PCT/ISA/210 (patent family annex) (July 2022)

**REFERENCES CITED IN THE DESCRIPTION**

**Patent documents cited in the description**

- WO 2021080002 A